Europäisches Patentamt

European Patent Office

Office européen des brevets

(19)

(11) Numéro de publication: **0 163 569**
**A1**

(12) ## DEMANDE DE BREVET EUROPEEN

(21) Numéro de dépôt: **85400923.0**

(22) Date de dépôt: **13.05.85**

(51) Int. Cl.⁴: **H 03 K 17/13**

(30) Priorité: **16.05.84 FR 8407708**

(43) Date de publication de la demande:
**04.12.85 Bulletin 85/49**

(84) Etats contractants désignés:
**AT BE CH DE FR GB IT LI LU NL SE**

(71) Demandeur: **AGENCE NATIONALE DE VALORISATION DE LA RECHERCHE (A.N.V.A.R.) Etablissement public de droit français**
**43, rue de Caumartin**
**F-75436 Paris Cédex 09(FR)**

(72) Inventeur: **Foch, Henri**
**33, rue Jean Tallien**
**F-31200 Toulouse(FR)**

(72) Inventeur: **Roux, Jacques**
**23, route d'Albi**
**F-31200 Toulouse(FR)**

(74) Mandataire: **Barre, Philippe**
**Cabinet Barre-Gatti-Laforgue 95 rue des Amidonniers**
**F-31069 Toulouse Cédex(FR)**

(54) **Interface de pilotage d'un interrupteur statique électronique à blocage commandable.**

(57) L'invention concerne une interface de pilotage (1) d'un interrupteur statique électronique (3) tel que thyristor blocable, interrupteur blocable à transistors; cette interface est interposée entre ledit interrupteur statique et un étage de commande (2) adapté pour engendrer un signal logique de commande. Ladite interface comprend un circuit (5) de détection de la tension entre les deux électrodes de puissance de l'interrupteur statique (3) et un circuit de pilotage (6) recevant le signal issu du circuit (5) et le signal de commande; ce circuit de pilotage est adapté pour assurer une polarisation de l'électrode de commande (3c) de l'interrupteur statique telle que:

— ladite polarisation corresponde au blocage de l'interrupteur lorsque le signal de commande porte un ordre de blocage ET/OU la tension entre électrodes de puissance est différente de O,

— ladite polarisation corresponde à l'état de conduction de l'interrupteur lorsque le signal de commande correspond à une autorisation de conduction ET la tension entre électrodes de puissance se trouve voisine de O.

Fig. 1

Croydon Printing Company Ltd

EP 0 163 569 A1

# INTERFACE DE PILOTAGE D'UN INTERRUPTEUR STATIQUE ELECTRONIQUE A BLOCAGE COMMANDABLE

L'invention concerne une interface de pilotage d'un interrupteur statique électronique à blocage commandable, plus particulièrement interrupteur à semiconducteurs ; elle vise une interface destinée à être interposée entre ledit interrupteur statique et un étage de commande adapté pour délivrer un signal de commande de l'interrupteur, fonction de l'application.

L'invention s'applique à tout interrupteur statique à blocage commandable, c'est-à-dire apte, sur un ordre de blocage, à interrompre le courant traversant ledit interrupteur à l'instant d'apparition dudit ordre de blocage ; l'invention vise en particulier les thyristors blocables, transistors à effets de champ, interrupteurs statiques blocables constitués d'association de transistors. Elle ne concerne pas les composants tels que thyristors conventionnels, triacs, dont l'électrode de commande peut provoquer la mise en conduction mais est inapte à provoquer le blocage instantané ; la conduction de ces derniers composants obéit à une logique très spécifique sans rapport avec celle des premiers et leur domaine d'application est tout à fait différent.

Les interrupteurs statiques visés par l'invention peuvent se définir comme :

. possédant au moins une électrode de commande et deux électrodes de puissance,

. étant aptes à présenter au moins deux états, un état de conduction caractérisé par une faible chute de tension entre les électrodes de puissance et un état de blocage caractérisé par un faible courant de fuite entre celles-ci,

. et se caractérisant en ce que les deux états correspondent à des polarisations différentes de l'électrode de commande, chaque changement d'état étant provoqué par un changement de polarisation de celle-ci.

Dans le brevet FR n° 78.32428 ou le brevet US n° 4 330 819, il est décrit un convertisseur statique utilisant des transistors dont la tenue en tension $V_{CEX}$ (tenue en tension à courant collecteur nul et base polarisée négativement) est très supérieure à sa tenue en tension $V_{CEO}$ (tenue en tension, base ouverte), et plus particulièrement des transistors "mésa-inversé" ; ce convertisseur est équipé d'un étage intermédiaire de traitement du signal de commande du ou des transistors sus-évoqués, adapté pour permettre d'exploiter en toute sécurité la plage de tenue en tension comprise entre $V_{CEO}$ et $V_{CEX}$ de façon à étendre considérablement le domaine des tensions d'alimentation du convertisseur. Un objectif de ce brevet était de fournir un convertisseur utilisable pour les tensions industrielles de 380 volts redressées.

La présente invention exclut les transistors ci-dessus évoqués et vise à réaliser le pilotage d'autres composants constitués par les interrupteurs statiques à semiconducteurs à blocage commandable définis précédemment (thyristors blocables, transistors à effets de champ...).

L'objectif essentiel de l'invention est de fournir une interface de pilotage de ces interrupteurs, qui, associée à ces derniers, réalise la fonction globale d'un interrupteur à mise en conduction spontanée et à blocage commandé, fonction correspondant à une logique "DUALE" de celle d'un thyristor conventionnel (la logique de fonctionnement d'un thyristor conventionnel est d'être commandable à l'amorçage et à blocage spontané).

Un autre objectif est de remplir la fonction sus-évoquée en assurant des commutations avec de très faibles pertes énergétiques.

Un autre objectif de l'invention est de supprimer la nécessité de circuits d'aide aux commutations d'amorçage et d'écarter toutes les contraintes qu'ils entraînent (temps morts de recouvrement, dissipation d'énergie). Les circuits d'aide aux commutations peuvent alors être spécialisés pour les commutations de blocage et être essentiellement capacitifs de façon à n'entraîner ni temps morts de recouvrement, ni dissipation de l'énergie stockée.

Un autre objectif de l'invention, découlant des deux précédents, est d'étendre en fréquence le domaine de fonctionnement habituel du ou des interrupteurs statiques pilotés.

A cet effet, conformément à l'invention, une interface de pilotage est interposée entre l'interrupteur statique et l'étage de commande qui est associé audit interrupteur pour en commander les commutations selon des séquences fonctions de l'application (cet étage de commande délivrant un signal de commande composé d'autorisations de conduction et d'ordres de blocage) ; ladite interface de pilotage comprend :

- un circuit de détection de la tension entre les deux électrodes de puissance de l'interrupteur statique, adapté pour délivrer un signal, dit signal de tension, fonction de ladite tension,

- un circuit de pilotage agencé pour recevoir, d'une part, le signal de tension issu du circuit de détection, d'autre part, le signal de commande issu de l'étage de commande et adapté :

. pour assurer une polarisation de l'électrode de commande correspondant au blocage de l'interrupteur statique dans les cas (a) ET/OU (b) :

(a) le signal de commande correspond à un ordre de blocage,

(b) la tension entre électrodes est différente de 0 (c'est-à-dire non voisine de 0),

. et pour assurer une polarisation de l'électrode de commande correspondant à l'état de conduction de l'interrupteur statique dans le seul cas où $\overline{(a)}$ ET $\overline{(b)}$ :

$\overline{(a)}$ le signal de commande correspond à une autorisation de conduction,

$\overline{(b)}$ la tension entre électrodes de puissance se trouve voisine de 0.

Ainsi l'interface de pilotage précitée permet de supprimer tout amorçage forcé de l'interrupteur statique ; en effet à chaque commutation, cette interface valide l'amorçage de l'interrupteur lorsque la tension entre les électrodes de puissance de celui-ci s'est annulée de façon naturelle. On supprime ainsi totalement les pertes énergétiques lors des commutations d'amorçage.

L'invention peut en particulier être

4 0163569

appliquée au pilotage de thyristors blocables ("G.T.O."), de transistors à effets de champ, à grille isolée ou non, et d'association de transistors bipolaires.

En outre, l'interface conforme à l'invention, qui permet un amorçage naturel non commandé de l'interrupteur statique, est tout particulièrement adaptée pour piloter un interrupteur statique dont les électrodes de puissance sont dotées d'un circuit essentiellement capacitif d'aide à la commutation en vue de dériver le courant entre ces électrodes au cours des commutations de blocage. On supprime ainsi les temps morts et les pertes énergétiques résultant de la dissipation de l'énergie stockée.

La description qui suit en référence aux dessins annexés, présente des exemples non limitatifs de l'invention ; sur ces dessins qui font partie intégrante de la présente description :

- la figure 1 est un schéma bloc montrant la disposition générale de l'interface de pilotage conforme à l'invention,

- les figures 2a, 2b, 2c et 2d sont des chronogrammes montrant l'allure des principaux signaux,

- la figure 3 est un schéma électronique montrant la structure de ladite interface dans le cas du pilotage d'un thyristor blocable "G.T.O.",

- les figures 4a, 4b, 4c et 4d sont des chronogrammes relatifs au montage de la figure 3,

- la figure 5 est un schéma électronique d'un autre mode de réalisation d'interface, adapté au pilotage d'un interrupteur statique comprenant des transistors bipolaires de puissance, notamment montés en "Darlington",

- les figures 6a, 6b et 6c sont des chronogrammes relatifs au montage de la figure 5.

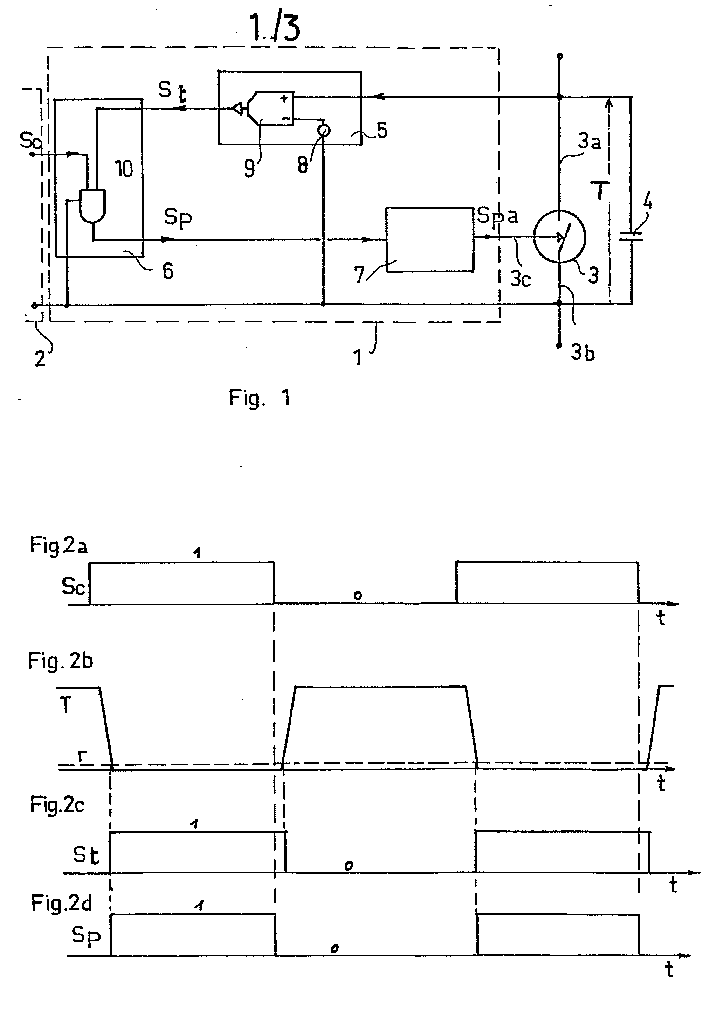

L'interface de pilotage représentée en 1 à la figure 1 est destinée à aménager un signal de commande délivré par un étage de commande 2, en vue de piloter un interrupteur statique électronique 3 qui en l'exemple est associé à un condensateur 4 d'aide à la commutation. Ce condensateur est destiné lors du blocage de l'interrupteur, à dériver le courant qui traverse ledit interrupteur, tout en limitant le gradient de tension apparaissant sur les électrodes de puissance lors du blocage.

L'interrupteur comporte deux électrodes de puissance 3a, 3b qui sont reliées au circuit de puissance en vue de contrôler les échanges d'énergie de ce circuit. Cet interrupteur comprend par ailleurs une électrode de commande 3c dont la polarisation détermine les états de l'interrupteur. Celui-ci peut présenter deux états : un état de conduction pour une polarisation déterminée de l'électrode de commande 3c, par exemple positive, et un état bloqué pour une polarisation différente, par exemple négative.

L'interface de pilotage 1 qui est interposée entre l'étage de commande 2 et l'interrupteur statique 3 comprend un circuit de détection 5 qui est connecté aux bornes des électrodes de puissance 3a et 3b de l'interrupteur 3 pour générer un signal de tension St fonction de la valeur de la tension T entre électrodes de puissance.

L'interface 1 comprend également un circuit de pilotage 6 qui est relié à l'étage de commande 2 et au circuit de détection 5 pour délivrer un signal de polarisation Sp à partir du signal de commande Sc et du signal de tension St. En l'exemple, ce signal de polarisation est ensuite adapté au type d'interrupteur statique utilisé par un circuit d'adaptation 7 qui délivre un signal de polarisation Spa permettant d'optimiser la commande de l'interrupteur.

Le circuit de détection 5 comprend un générateur de tension de référence 8 fournissant une tension de référence -r- de très faible valeur par rapport à la valeur maximale de la tension T entre électrodes de puissance 3a, 3b ; la valeur de -r- est choisie de sorte que lorsque la tension T entre les électrodes de puissance devient inférieure à cette tension de référence -r-, l'amorçage de l'interrupteur n'entraîne que des pertes négligeables ; la tension -r- peut être de l'ordre de 1/100 de la valeur maximale de la tension T.

Le circuit 5 comprend en outre un comparateur inverseur 9, relié aux électrodes de puissance et au générateur 8. Ce comparateur délivre un signal de tension St à deux états, en fonction des valeurs relatives des tension de référence -r- et tension T entre électrodes de puissance.

La figure 2b représente ·la tension T entre électrodes de puissance et la tension de référence -r-. La figure 2c illustre l'allure du signal de tension St. Ce signal présente deux états :

- l'un (symbolisé par l'état logique 1 à la figure 2c) correspondant à une tension T inférieure à -r-, c'est-à-dire voisine de 0,

- l'autre (symbolisé par l'état logique 0) correspondant à une tension T supérieure à -r-, c'est-à-dire non voisine de 0.

Par ailleurs, le circuit de pilotage 6 comprend une unité logique 10 adaptée pour réaliser une fonction logique, en l'exemple fonction ET, sur le signal de tension St issu du circuit 5 et le signal de commande Sc issu de l'étage de commande 2.

Ce signal de commande Sc est illustré à la figure 2a ; il possède deux niveaux, l'un (symbolisé par l'état logique 1) correspondant à une autorisation de conduction, l'autre (symbolisé par l'état logique 0) correspondant à un ordre de blocage. Ce signal de commande Sc est élaboré dans chaque application pour engendrer les commutations désirées de l'interrupteur statique 3.

L'unité logique 10 délivre à partir du signal Sc et du signal St, un signal de polarisation Sp à deux niveaux (figure 2d) :

- un niveau (désigné par 1 à la figure 2d) correspondant à l'état de conduction de l'interrupteur 3, ce niveau apparaissant lorsque Sc = 1 ET St = 1,

- un niveau (désigné par 0) correspondant à l'état de blocage de l'interrupteur 3, ce niveau apparaissant dans tous les autres cas, c'est-à-dire si Sc = 0 ou si St = 0.

Le circuit d'adaptation 7, qui dépend de la nature de l'interrupteur utilisé et dont des exemples sont fournis plus loin, fournit un signal de polarisation adapté Spa, qui présente une forme analogique synchrone avec le signal Sp, cette forme étant adaptée aux exigences de la commande de l'interrupteur 3 considéré.

Lorsqu'apparaît une transition montante du signal Sp, l'interrupteur statique est commandé à la conduction par une polarisation correspondante de son électrode de commande ; cette commande correspond à un ordre de conduction du signal Sc, mais est décalée par rapport à celui-ci jusqu'à ce que la tension T entre électrodes de puissance s'effondre. Ainsi, l'amorçage n'est commandé par l'interface que pour des tensions T voisines de 0, de sorte que les pertes énergétiques d'amorçage deviennent négligeables.

Le circuit d'aide à la commutation peut être constitué par un simple condensateur 4 puisque le pilotage sus-évoqué interdit l'amorçage de l'interrupteur statique tant que le condensateur n'est pas totalement déchargé : en conséquence, l'interrupteur ne subit jamais les surintensités de décharge du condensateur lors de ses mises en conduction.

Il est à noter que l'interface de pilotage 1 visée par l'invention ne provoque pas l'effondrement de la tension T entre électrodes de puissance ; cet effondrement nécessaire doit être provoqué par le circuit externe à l'interrupteur, soit naturellement de par sa structure et ses conditions de fonctionnement (par exemple onduleur de tension non modulée débitant sur un circuit inductif), soit par le jeu d'un circuit auxiliaire adapté pour provoquer cet effondrement (par exemple circuits réactifs non dissipatifs tels que circuits oscillants, inductances..., ou interrupteurs statiques auxiliaires associés à ces derniers).

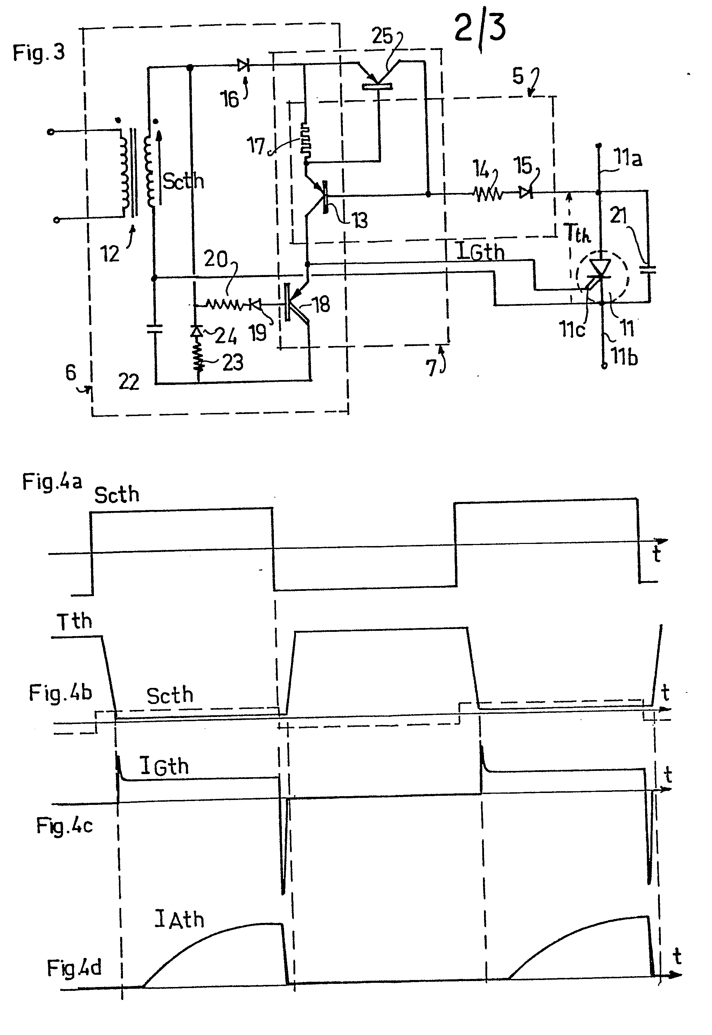

La figure 3 représente une interface de pilotage d'un thyristor blocable (G.T.O.) 11 dont les électrodes de puissance, désignées par anode et cathode dans ce cas, sont référencées 11a et 11b, et l'électrode de commande, désignée par gachette, est référencée 11c. Un condensateur 21 d'aide à la commutation est mis en parallèle sur les anode et cathode de ce thyristor blocable.

L'étage de commande alimente l'interface de pilotage par l'entremise d'un transformateur d'isolement 12 et fournit simultanément le signal de commande Scth à cette interface ; ce signal Scth considéré au secondaire du transformateur présente une amplitude maximum positive, qui joue le rôle de tension de référence -r- et qui est très faible par rapport à la tension maximale entre anode et cathode du thyristor blocable.

La détection de la tension entre anode et cathode Tth est effectuée par un transistor 13 dont la base est connectée à l'anode 11a par l'entremise d'une résistance 14 et d'une diode 15, laquelle est agencée pour conduire du transistor 13 vers l'anode 11a.

En outre, le transistor 13 est monté avec son émetteur relié au transformateur 12 par l'entremise d'une diode 16 et d'une résistance 17. Ainsi, ce transistor 13 fait également fonction d'unité logique ET (10) puisqu'il ne peut être conducteur que lorsque les conditions suivantes se produisent à la fois :

- signal de commande Scth positif, ET

- tension Tth inférieure à la valeur de Scth, c'est-à-dire voisine de 0.

(Les deux diodes 16 et 15 sont rendues passantes lorsque ces conditions sont simultanément satisfaites, la base du transistor 13 se trouvant alors alimentée).

De plus, le circuit de pilotage comprend un transistor 18 agencé pour transmettre les ordres de blocage du signal de commande Scth à la gachette 11c du thyristor blocable. A cet effet, une diode 19 et une résistance 20 transmettent à la base du transistor 18 le signal de commande fourni par le transformateur 12. Pour les valeurs négatives du signal de commande, le transistor 18 bloque le thyristor 11 par polarisation négative de sa gachette.

Cette polarisation est issue d'un condensateur 22 placé en série avec une résistance 23 et une diode 24, permettant la recharge du condensateur à chaque alternance négative du signal de commande Scth.

Par ailleurs, la fonction d'adaptation est réalisée, d'une part, par les transistors 13 et 18 déjà évoqués, d'autre part, par un transistor 25 agencé pour shunter la jonction base/émetteur du transistor 13 afin de stabiliser le courant délivré par ce dernier ; ce courant est détecté par la résistance 17 précitée.

Le transistor 18 cesse de conduire dès que la jonction gachette/cathode du thyristor 11 est bloquée ; il n'assure plus alors qu'une polarisation négative de ladite jonction.

Le circuit ci-dessus décrit remplit donc les fonctions déjà évoquées de l'interface de pilotage mais, aux fins de simplification, plusieurs de ses composants participent à plusiseurs fonctions : ainsi par exemple, le transistor 13 sert à la fois à la détection, au pilotage et à l'adaptation. On a schématisé ces fonctions multiples en dessinant à la figure 3 les circuits de base avec des chevauchements pour les composants faisant partie de plusieurs circuits, (les références 5, 6 et 7 de la figure 1 sont réutilisées pour ces circuits de base).

Il est à noter que l'agencement particulier des composants de l'interface illustrée réalise également une fonction globale de différentiation délivrant des impulsions opposées lors de l'amorçage du transistor 13 et lors de l'amorçage du transistor 18. Dans d'autres exemples de circuit, un différentiateur (capacité ou autre) peut être prévu pour réaliser cette fonction.

Les figures 4a, 4b, 4c et 4d illustrent l'allure des signaux principaux dans l'interface précitée :

- figure 4a : signal de commande Scth (secondaire du transformateur 12),

- figure 4b : signal de tension Tth (entre anode et cathode du thyristor 11),

- figure 4c : courant de gachette Igth commandant les commutations du thyristor 11,

- figure 4d : courant d'anode Iath image du fonctionnement du thyristor.

En l'exemple, le signal Scth est alternatif, rectangulaire.

Lorsque le signal Tth devient inférieur au signal Scth, le circuit d'adaptation 7 fournit sur la gachette du thyristor blocable une impulsion positive d'amorçage qui engendre l'état de conduction de celui-ci (figure 4c). Ensuite, ce circuit délivre un signal d'entretien pendant toute la période de conduction. Enfin, lors de la transition descendante du signal Scth, ce circuit engendre une impulsion négative de courant de gachette (impulsion de blocage) qui engendre l'état de blocage du thyristor.

Le courant d'anode Iath, illustré à la figure 4d, apparaît entre les deux impulsions d'amorçage et de blocage du courant de gachette, lorsque le circuit extérieur sur lequel débite le thyristor le permet. Le blocage du thyristor et, donc, l'annulation de son courant d'anode interviennent lors de l'apparition de l'impulsion de blocage du courant de gachette.

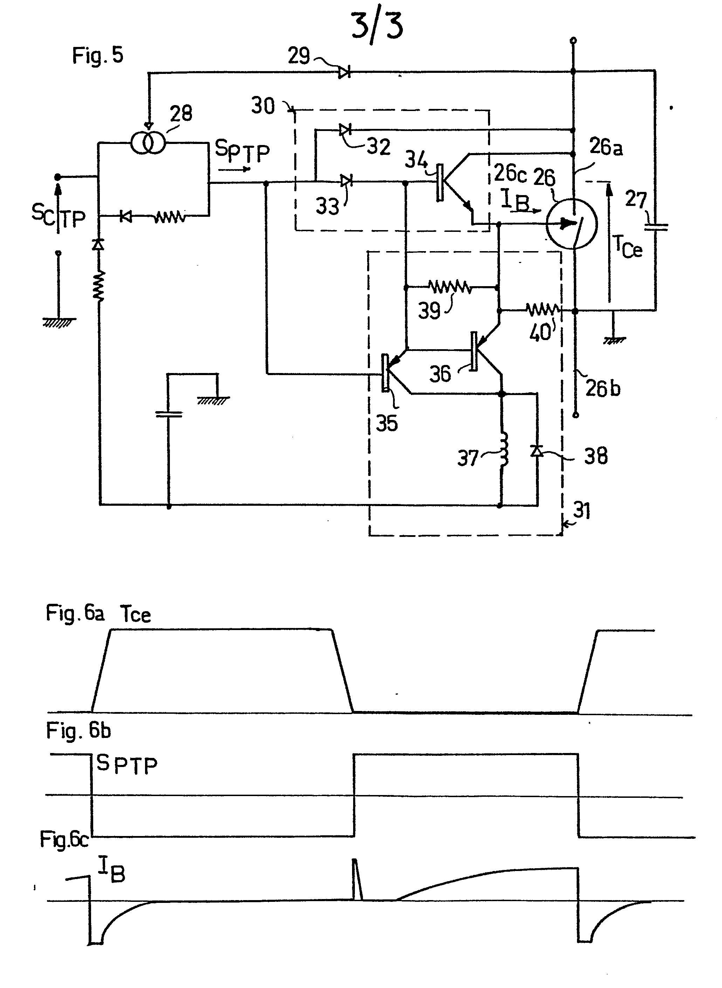

Par ailleurs, la figure 5 représente une interface de pilotage d'un interrupteur statique 26 qui est constitué par une association de transistors bipolaires, notamment montés en Darlington. Les électrodes de puissance de cet interrupteur sont référencées 26a et 26b et l'électrode de commande est référencée 26c ; un condensateur 27 d'aide à la commutation est mis en parallèle entre les électrodes de puissance de l'interrupteur 26.

L'interface de pilotage a une structure globale analogue à la précédente, à l'exception de la fonction d'adaptation, qui comprend dans ce cas deux circuits spécifiques décrits plus loin (encadrés en traits discontinus à la figure 5) ; en outre, dans un but de simplification, l'ensemble des transistors 13, 25 et résistances 14 et 17 est symbolisé à la figure 5 par une source de courant 28 commandée par une diode 29 (équivalente à la diode 15 de l'interface précédente).

Le circuit d'adaptation du courant de l'électrode de commande de l'interrupteur 26 comprend un circuit d'antisaturation 30 agencé pour délivrer sur l'électrode de commande de l'interrupteur 26 un courant sensiblement proportionnel au courant traversant l'interrupteur à travers ses électrodes de puissance et un circuit 31 d'extraction de courant inverse de commande, adapté pour générer le courant de blocage.

Le circuit d'antisaturation 30 est en l'exemple constitué de deux diodes 32 et 33 et d'un transistor 34. Durant la phase de conduction de l'interrupteur statique

11 0163569

26, les deux diodes 32 et 33 conduisent simultanément, imposant au transistor 34 une tension collecteur/base voisine de 0 ; ainsi, le transistor 34 se trouve en quasi-saturation et fournit à l'interrupteur 26 un courant de commande sensiblement proportionnel au courant qui le traverse entre ses électrodes de puissance.

Le circuit 31 comprend deux transistors 35 et 36 qui connectent successivement une inductance 37 à la base du transistor 34, puis à l'électrode de commande de l'interrupteur 26, afin de provoquer les blocages successifs des transistors 34 et 26. L'énergie stockée dans l'inductance 37 est ensuite évacuée dans une diode 38. Deux résistances 39 et 40 abaissent les résistances d'entrée des transistors 34 et 26.

Les figures 6a, 6b et 6c illustrent l'allure des signaux essentiels relatifs à l'interface de pilotage ci-dessus décrite.

Le signal de polarisation Sptp se présente dans cet exemple sous forme d'un courant à peu près rectangulaire tel qu'illustré à la figure 6b. Les transitions de ce courant correspondent aux passages au voisinage de 0 de la tension Tce entre électrodes de puissance de l'interrupteur 26 (figure 6a).

A partir de la transition positive du courant Sptp et durant son palier positif (correspondant à l'état de conduction), le circuit d'antisaturation 30 fournit successivement à l'électrode de commande de l'interrupteur 26 (figure 6c) : une impulsion de courant positive et un courant de commande sensiblement proportionnel au courant traversant l'interrupteur 26 entre ses électrodes de puissance.

Lors de l'apparition de la transition négative du courant Sptp (correspondant à l'ordre de blocage), le circuit 31 fournit un courant négatif de blocage sur l'électrode de commande de l'interrupteur 26.

Le courant parvenant à l'électrode de commande de l'interrupteur 26 est ainsi adapté, d'une part, aux variations du courant traversant ce dernier, d'autre part, à la rapidité de blocage de celui-ci.

L'interface conforme à l'invention peut

12

0163569

également être appliquée au pilotage d'un transistor à effets de champ (à grille isolée ou non) ; dans ce cas, la faible valeur du courant de polarisation qui est nécessaire pour engendrer les commutations de ce type d'interrupteurs statiques permet de simplifier, voire de supprimer le circuit d'adaptation.

0163569

REVENDICATIONS

1/ - Interface de pilotage d'un interrupteur statique électronique, destinée à être interposée entre :

- un étage de commande adapté pour engendrer un signal logique de commande (Sc) comportant des ordres de blocage et des autorisations de conduction,

- et un interrupteur statique (3) à blocage commandable du type thyristors blocables, transistors à l'exclusion des transistors discrets ayant une tenue en tension $V_{CEX}$ supérieure à leur tenue en tension $V_{CEO}$, ledit interrupteur statique :

. possédant au moins une électrode de commande (3c) et deux électrodes de puissance (3a, 3b),

. étant apte à présenter au moins deux états, un état de conduction caractérisé par une faible chute de tension entre les électrodes de puissance et un état de blocage caractérisé par un faible courant de fuite entre celles-ci ;

. et se caractérisant en ce que les deux états correspondent à des polarisations différentes de l'électrode de commande, chaque changement d'état étant provoqué par un changement de polarisation de celle-ci, ladite interface de pilotage comprenant ;

- un circuit (5) de détection de la tension entre les deux électrodes de puissance de l'interrupteur statique, adapté pour délivrer un signal, dit signal de tension (St), fonction de ladite tension,

- un circuit de pilotage (6) agencé pour recevoir, d'une part, le signal de tension (St) issu du circuit de détection, d'autre part, le signal de commande (Sc) issu de l'étage de commande et adapté :

. pour assurer une polarisation de l'électrode de commande (3c) correspondant au blocage de l'interrupteur statique dans les cas (a) ET/OU (b) :

(a) le signal de commande Sc correspond à un ordre de blocage,

(b) la tension entre électrodes est différente de 0,

. et pour assurer une polarisation de

14

**0163569**

l'électrode de commande (3c) correspondant à l'état de conduction de l'interrupteur statique dans le seul cas où (a) ET (b) :

(a) le signal de commande (Sc) correspond à une autorisation de conduction,

(b) la tension entre électrodes de puissance se trouve voisine de 0.

2/ - Interface de pilotage selon la revendication 1, dans laquelle :

- le circuit de détection (5) relié aux électrodes de puissance (3a, 3b) est adapté pour fournir un signal de tension (St) à deux états, l'un correspondant à une tension entre électrodes de puissance voisine de 0, l'autre à une tension différente,

- le circuit de pilotage (6), relié au circuit de détection (5) pour recevoir le signal de tension (St) précité et à l'étage de commande (2) pour recevoir le signal de commande (Sc), est adapté pour réaliser une fonction logique sur ces signaux en vue de délivrer à l'électrode de commande un signal de polarisation à deux niveaux :

. un niveau correspondant au blocage de l'interrupteur statique, apparaissant au cours des ordres de blocage du signal de commande ET/OU pour l'état du signal de tension correspondant à une tension différente de 0,

. un niveau correspondant à l'état de conduction de l'interrupteur statique, apparaissant durant les phases d'autorisations de conduction du signal de commande ET pour l'état du signal de tension correspondant à une tension voisine de 0.

3/ - Interface de pilotage selon la revendication 2, dans laquelle le circuit de détection (5) comprend un générateur (8) de tension de référence (r) de très faible valeur par rapport à la tension maximale entre électrodes de puissance (3a, 3b), et un comparateur (9) relié aux électrodes de puissance et audit générateur et adapté pour délivrer le signal de tension (St) à deux états sus-évoqué en fonction des valeurs relatives des tension de référence et tension entre électrodes de puissance.

4/ - Interface de pilotage selon l'une des

0163569

revendications 2 ou 3, dans laquelle un circuit d'adaptation (7) est intercalé entre la sortie du circuit de pilotage (6) et l'électrode de commande (3c) de l'interrupteur statique en vue d'adapter le signal de polarisation au type d'interrupteur statique utilisé.

5/ - Interface conforme à l'une des revendications précédentes, appliquée au pilotage d'un interrupteur statique doté entre ses électrodes de puissance, d'un circuit capacitif d'aide à la commutation (4).

6/ - Interface selon l'une des revendications 1, 2, 3, 4 ou 5, appliquée au pilotage d'un thyristor blocable (11).

7/ - Interface de pilotage selon les revendications 4 et 6 prises ensemble, dans laquelle le circuit d'adaptation est agencé pour adapter le signal de polarisation en vue de délivrer sur l'électrode de commande du thyristor blocable (11) :

- un signal d'entretien pendant la conduction,

- une impulsion de blocage pour engendrer l'état de blocage.

8/ - Interface de pilotage selon la revendication 7, dans laquelle le circuit d'adaptation est agencé pour réaliser une fonction de différentiation de façon à délivrer des impulsions opposées lors des transitions du signal de polarisation.

9/ - Interface selon l'une des revendications 1, 2, 3, 4 ou 5, appliquée au pilotage d'un interrupteur statique (26) comprenant des transistors bipolaires.

10/ - Interface de pilotage selon les revendications 4 et 9 prises ensemble, dans laquelle le circuit d'adaptation est agencé pour adapter le signal de polarisation en vue de délivrer sur l'électrode de commande de l'interrupteur statique (26) :

- un courant pendant la conduction, sensiblement proportionnel au courant traversant l'interrupteur entre ses électrodes de puissance,

- un courant de blocage pour engendrer l'état de blocage.

16

11/ - Interface de pilotage selon la revendication 10, dans laquelle le circuit d'adaptation comprend un circuit (30) d'antisaturation de l'interrupteur délivrant sur l'électrode de commande de celui-ci le courant sensiblement proportionnel au courant traversant l'interrupteur et un circuit (31) d'extraction de courant inverse de commande, adapté pour générer le courant de blocage.

12/ - Interface selon l'une des revendications 1, 2, 3, 4 ou 5, appliquée au pilotage d'un transistor à effet de champ.

Fig. 1

Fig 2a

Fig. 2b

Fig. 2c

Fig. 2d

Fig.3

Fig.4a Scth

Fig.4b

Fig.4c

Fig 4d

Fig. 5

Fig. 6a  Tce

Fig. 6b

SPTP

Fig.6c

$I_B$

**0163569**

Numéro de la demande

**RAPPORT DE RECHERCHE EUROPEENNE**

Office européen
des brevets

EP 85 40 0923

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int Cl 4) |
|---|---|---|---|
| X | ELEKTOR, vol. 5, no. 5, mai 1979, pages 5-13 - 5-16, Canterbury, GB; "Switching mains-powered equipment" * Page 5-14, colonne du milieu, ligne 9 - colonne de droite, ligne 24; figure 2 * | 1-3,5,6 | H 03 K 17/13 |
| | --- | | |
| X | FR-A-2 499 789 (THOMSON-CSF) * Page 9, ligne 26 - page 10, ligne 35; figure 3 * | 1-4,6 | |
| | ----- | | |

DOMAINES TECHNIQUES
RECHERCHES (Int. Cl.4)

H 03 K
H 02 M

Le présent rapport de recherche a été établi pour toutes les revendications

| Lieu de la recherche | Date d'achèvement de la recherche | Examinateur |
|---|---|---|
| LA HAYE | 12-08-1985 | CANTARELLI R.J.H. |